Europäisches Patentamt

European Patent Office

Office européen des brevets

(11) Publication number : **0 292 340 B1**

(12) **EUROPEAN PATENT SPECIFICATION**

(45) Date of publication of patent specification :
07.09.94 Bulletin 94/36

(21) Application number : 88400667.7

(22) Date of filing : 21.03.88

(51) Int. Cl.⁵ : **H01L 39/12**, H01L 39/24, C04B 35/00

(54) Process for preparing superconducting material.

(30) Priority : 19.03.87 JP 65281/87

(43) Date of publication of application :
23.11.88 Bulletin 88/47

(45) Publication of the grant of the patent :
07.09.94 Bulletin 94/36

(84) Designated Contracting States :
DE FR GB

(56) References cited :
US-A- 3 932 315
ZEITSCHRIFT FÜR PHYSIK B-CONDENSED
MATTER, vol. 64, no. 2, 1986, pages 189-193,
Springer-Verlag; J.G. BEDNORZ et al.:
"Possible high Tc superconductivity in the
Ba-La-Cu-O system"
REVUE DE CHIMIE MINERALE, t 21, 1984, p.
407-425
PHYSICAL REV. LETT. 58(9), 2.3.1987, P.
908-910
PHYS. REV. LETT., 58(4), 26.1.1987, p. 405-407
Journal of Applied Physics, 56(8), 15.10.1984,
p. 2330-2332

(73) Proprietor : SUMITOMO ELECTRIC
INDUSTRIES LIMITED
No. 15, Kitahama 5-chome,
Higashi-ku
Osaka-shi, Osaka 541 (JP)

(72) Inventor : Fujita, Nobuhiko Itami Works of
Sumitomo
Electric Industries, Ltd.
1-1, Koyakita 1-Chome
Itami-shi Hyogo (JP)
Inventor : Kobayashi, Tadakazu Itami Works of
Sumitomo
Electric Industries, Ltd.
1-1, Koyakita 1-Chome
Itama-shi Hyogo (JP)
Inventor : Itozaki, Hideo Itami Works of
Sumitomo
Electric Industries, Ltd.
1-1, Koyakita 1-Chome
Itami-shi Hyogo (JP)
Inventor : Tanaka, Saburo Itami Works of
Sumitomo
Electric Industries, Ltd.
1-1, Koyakita 1-Chome
Itami-shi Hyogo (JP)
Inventor : Yazu, Shuji Itami Works of Sumitomo
Electric Industries, Ltd.
1-1, Koyakita 1-Chome
Itami-shi Hyogo (JP)
Inventor : Jodai, Tetsuji Itami Works of
Sumitomo
Electric Industries, Ltd.
1-1, Koyakita 1-Chome
Itami-shi Hyogo (JP)

(74) Representative : Lemoine, Michel et al
Cabinet Bernasconi et Vigier
13 boulevard des Batignolles
F-75008 Paris (FR)

## Description

Background of the Invention

Field of the invention

The present invention relates to superconducting materials, more particularly, it relates to a new superconducting material which possesses a high critical temperature of superconductivity and a reduced discrepancy between the critical temperature and the onset temperature where the phenomenon of superconductivity is initially observed and which shows enough stability in superconducting properties, as well as to a process for preparing the same in the form of a block of in the form of a thin film.

Description of the related art

Under the superconducting condition, a perfect diamagnetism is observed and no difference in potential is observed for an electric current of a constant finite value, and hence, a variety of applications of superconductivity have been proposed in the field of electric power transmission as a means for delivering electric power without loss.

The superconductivity can be utilized in the field of electric power applications such as MHD power generation, power transmission, electric power reservation or the like; in the field of transportation, for example magnetic levitation trains, or magnetically propelled ships; in the medical field such as high-energy beam radiation units; in the field of science such as NMR or high-energy physics; highly sensitive sensors or detectors for sensing very weak magnetic fields, microwave, radiant ray or the like, or in the field of fusion power generation.

In addition to the abovementioned electric power applications, the superconducting materials can be used in the field of electronics, for example, as a Josephson device which is an indispensable switching device for realizing a high-speed computer which consumes a very reduced power.

However, their actual use has been restricted because the phenomenon of superconductivity can be observed only at very low cryogenic temperatures. Among known superconducting materials, a group of materials having so-called A-15 structure show rather higher Tc (critical temperature of superconductivity) than others, but even the top record of Tc in the case of $Nb_3Ge$ which showed the highest Tc could not exceed 23.2 K at most. This means that liquidized helium (boiling point of 4.2 K) is the only cryogen which can realize such very low temperatures of Tc. However, helium is not only a limited costly resource but also requires a large-scaled system for liquefaction. Therefore, there has been a strong demand for other superconducting materials having higher Tc. However no material which exceeded the abovementioned Tc had been found from studies over the past ten years.

The possibility of an existence of new types of superconducting materials having much higher Tc was revealed by Bednorz and Müller, who discovered a new oxide type superconductor in 1986 [Z. Phys. B64 (1986) 189].

This new oxide type superconducting material is $[La, Ba]_2CuO_4$ or $[La, Sr]_2CuO_4$ which are called the $K_2NiF_4$-type oxides, having a crystal structure which is similar to known perovskite type oxides. The $K_2NiF_4$-type oxides show such higher Tc as 30 to 50 K, which are extremely higher than those of known superconducting materials, and hence it becomes possible to use liquidized hydrogen (b.p. = 20.4 K) or liquidized neon (b.p. = 27.3 K) as a cryogen which can bring them to exhibit the superconductivity.

It was also reported that C. W. Chu et al discovered, in the United States of America, another type of superconducting material having a critical temperature in the order of 90 K in February 1987, and hence the possibility of existence of high-temperature superconductors has burst onto the scene.

Generally, in the case of the abovementioned superconducting materials, there is a large discrepancy or difference between the onset temperature "Tc" (from where superconducting phenomenon starts to be observed) and the critical temperature "Tcf" (from where resistivity vanishes completely and hence the complete superconductivity is realized). Therefore, in a practical use, these superconductors must be cooled down to a temperature which is fairly lower than the onset temperature "Tc", and it is requested to reduce the abovementioned discrepancy or difference between "Tc" and "Tcf".

Furthermore, superconductivity breaks down in a strong magnetic field. The critical field "Hc" which is a definite value of magnetic field from where superconductivity breaks down is dependent on temperature. Specifically both the critical temperature "Tc" and the critical magnetic field "Hc" are critical factors when superconductors are applied for practical uses. Therefore, it is also requested to improve the stability of superconductivity at the critical magnetic field.

The inventors of the present invention tried to solve the abovementioned problems by adding additional elements to the relatively high temperature superconductors which were discovered recently. It was expected that the addition of specified elements would improve a variety of properties of the superconducting materials so as to obtain higher critical current density and the stability of the critical current density under a strong magnetic field.

Experiments carried out by the present inventors revealed that the addition of one or more than one element selected from a group consisting of V, Ta, Nb, Cr, Ga, In, Cd, Sn, Tl, Pb, Mo, W and Zn, to the compound oxide type superconducting materials, brings improvements in the properties of superconductivity, so as to obtain superconducting materials which exhibit a reduced discrepancy of difference between "Tc" and Tcf" and whose superconductivity is not broken down under stronger magnetic field.

Therefore, an object of the present invention is to solve the abovementioned problems and to provide a new superconducting material which exhibits a reduced discrepancy or difference between "Tc" and "Tcf" and whose superconductivity is not broken down under stronger magnetic field, as well as to provide a process for producing the same in the form of bulk or block or in the form of a thin film.

Summary of the Invention

The present invention provides superconducting materials having a composition represented by the general formula:

$$A_uB_vC_wCu_xO_y$$

in which,

"A" represents one element selected from elements of IIa group and IIIa group of the Periodic Table,

"B" represents one element selected from elements of IIa group and IIIa group of the Periodic Table, "B" being selected from the group which "A" is not selected from,

"C" represents at least one element selected from a group consisting of vanadium (V), tantalum (Ta), niobium (Nb), chromium (Cr), gallium (Ga), indium (In), cadmium (Cd), tin (Sn), thallium (Tl), lead (Pb), molybdenum (Mo), tungsten (W) and zinc (Zn), and

each of "u", "v", "w" and "x" represents a number selected in a range of 0 to 1, and "y" represents a number which is selected from a range of 1 to 4.

A portion of the oxygen may be substituted by the other element or elements selected from a group consisting of boron (B), carbon (C), nitrogen (N), fluorine (F) and sulfur (S).

A portion of the copper may be substitued by other element or elements selected from a group consisting of Ib group, IIb group, IIIb group and VIII group of the Periodic Table, for example titanium (Ti).

Generally, the element "A" is one element selected from elements of IIa group of the Periodic Table, while the element "B" is one element selected from IIIa group of the Periodic Table. As preferred combination of the element "A" and the element "B", it can be mentioned a combination of Ba and Y and a combination of Sr and La. A portion of the Ba and/or Y, or of Sr and/or La may be substituted by an other element or elements selected from elements of IIa group and IIIa group of the Periodic Table such as calcium (Ca).

The atom ratio of the elements "A", "B", "C" and "Cu", namely the values of "u", "v", "w" and "x" in the formula, is selected in a range of 0 to 1 respectively. Under this condition, the value of "y" is selected from a range of 1 to 4.

For example, in the case of a compound oxide of elements of Ba, Y, Cu and "C", the atom ratio of Ba:Y:Cu:"C" is preferably selected in a range of (0.5 to 2):(0.5 to 3):(1 to 4):(0.01 to 0.1). The compound oxide preferably contains perovskite type oxide or quasi-perovskite type oxide. The term quasi-perovskite type oxide means a structure which can be considered to have a crystal structure that is similar to perovskite-type oxides and includes an orthorhombically distorted perovskite or a distorted oxygen-deficient perovskite or the like.

The present invention also provides a process for producing the abovementioned superconducting material, characterized by sintering a mixture of the following powders:

an oxide, carbonate, nitrate or sulfate of one element "A" selected from elements of IIa group and IIIa group of the Periodic Table,

an oxide, carbonate, nitrate or sulfate of one element "B" selected from elements of IIa group and IIIa group of the Periodic Table, "B" being selected from the group which "A" is not selected from,

an oxide, carbonate, nitrate or sulfate of at least one element "C" selected from a group consisting of vanadium (V), tantalum (Ta), niobium (Nb), chromium (Cr) gallium (Ga), indium (In), cadmium (Cd), tin (Sn), thallium (Tl), lead (Pb), molybdenum (Mo), tungsten (W) and zinc (Zn), and

an oxide, carbonate, nitrate or sulfate of copper,

wherein the atom ratio of these elements "A":"B":"C":"Cu" in the mixture of powders is adjusted to (0 to 1):(0 to 1):(0 to 1):(0 to 1).

Selection of the starting materials or the elements "A", "B", "C" and "Cu" and the preferred atom ratio thereof may be effected in the same manner as in the abovementioned description.

The compound oxide of the elements "A", "B", "C" and "Cu" is produced by the abovementioned sintering. Specifically oxygen (O) is introduced into the sintered mass. The other elements selected from the abovementioned elements "E" can be introduced into the sintered mass of the presence of these elements "E". In practice, powders of nitrides of boron and/or carbon, fluorides and/or sulfates of the abovementioned other elements "A", "B" and "C" may be mixed in the starting material powders. It is also possible to introduce a gas or gases of the elements "E" of a halogenated compound gas into the sintering atmosphere directly.

According to a preferred embodiment of the present invention, powders or oxides, carbonates, nitrates or sulfates of elements Ba, Y, Cu and the element "C" are mixed with such proportions that the atom ratio of Ba:Y:Cu:"C" is selected in a range of (0.5 to 2):(0.5 to 3):(1 to 4):(0.01 to 0.1).

The sintering can be carried out at a temperature ranging from 700 °C to 1,600 °C, preferably from 800 °C to 1,000 °C. This sintering operation is preferably carried out through at least two stages including a preliminary sintering of the mixture of powders, and a final sintering comprising pulverizing of the preliminary sintered body, compacting the pulverized powder and finally sintering the compacted powder. The preliminary sintering may be carried out at a temperature ranging from 550 °C to 950 °C, and the final sintering may be carried out at a temperature ranging from 800 °C to 930 °C.

It is also preferable to heat-treat the resulting sintered body further. This heat-treatment may be carried out at a temperature ranging from 750 to 1,500 °C, preferably at a temperature ranging from 750 to 930 °C.

The present invention also provides a method for producing a superconducting thin film by a physical vapor deposition technique, characterized in that a target used in the physical vapor deposition technique is a compound oxide which contains one element "A" selected from elements of IIa group and IIIa group of the Periodic Table, one element "B" selected from elements of IIa group and IIIa group of the Periodic Table "B" being selected from the group which "A" is not selected from,, at least one element "C" selected from a group consisting of vanadium (V), tantalum (Ta), niobium (Nb), chromium (Cr), gallium (Ga), indium (In), cadmium (Cd), tin (Sn), thallium (Tl), lead (Pb), molybdenum (Mo), tungsten (W) and zinc (Zn), and copper, the atom ratio of said elements "A", "B","C" and "Cu" being adjusted to such a range that the atom ratio of "A":"B":"C":"Cu" in the target is (0 to 1):(0 to 1):(0 to 1):(0 to 1) in order to produce a thin film of perovskite type oxide or quasi-perovskite type oxide.

The target itself is preferably made of perovskite type oxide or quasi-perovskite type oxide.

According to the preferred embodiment, the element "A" is barium (Ba) and the element "B" is yttrium (Y). In this case, the target may be prepared from a preliminary sintered mass which is produced by preliminary sintering a mixture of powders of oxides, carbonates, nitrates or sulfates of said elements Ba, Y, Cu and said element "C" which are mixed with such proportions that the atom ratio of Ba:Y:Cu:"C" is selected in a range of (0.5 to 2):(0.5 to 3):(1 to 4):(0.01 to 0.1) at a temperature ranging from 250 to 1,200 °C. The term preliminary sintering means that the powder material is subjected to heat-treatment or calcinated or sintered to produce a compound oxide.

It is also possible to use, as the target, a finally sintered mass which is produced by further sintering said preliminary sintered mass at a temperature ranging from 700 to 1,000 °C.

The target may be in form of a powder prepared from the preliminary sintered mass or the finally sintered mass, or in form of a block of the preliminary sintered mass or the finally sintered mass. It is also possible to use, as the target, a plurality of target segments each of which may be an oxide of Ba, Y, Cu and the element "C" respectively or for example, a combination of $(Ba, Y)O_x$ and $CuO$, wherein "x" represents a number of $1 \leqq x$.

The atom ratio of Ba, Y, Cu and the element "C" in the target can be adjusted as a function of evaporation rates of Ba, Y, Cu and the element "C" on the basis of the atom ratio of Ba, Y, Cu and the element "C" in a thin film to be produced.

Generally, an atmosphere of vaporization contains Ar and $O_2$, the partial pressure of Ar being preferably adjusted in a range from 0.13 to 40 Pa ($1.0 \times 10^{-3}$ to $3 \times 10^{-1}$ Torr), preferably 0.67 to 40 Pa ($5.0 \times 10^{-3}$ to $3 \times 10^{-1}$ Torr), while the partial pressure of $O_2$ is preferably adjusted in a range from 0.13 to 40 Pa ($1.0 \times 10^{-3}$ to $3 \times 10^{-1}$ Torr). When the partial pressure of Ar exceeds 40 Pa ($3 \times 10^{-1}$ Torr), glow discharge occurs, so that deposition of oxide which exhibits a desired superconducting property can not be obtained. If the partial pressure of $O_2$ is not higher than 0.13 Pa ($1.0 \times 10^{-3}$ Torr), the resulting thin film does not contain a satisfactory amount of perovskite type oxide or quasi-perovskite type oxide because of poor crystal structure. When the partial pressure of $O_2$ exceeds 40 Pa ($3 \times 10^{-1}$ Torr), the deposition rate becomes too slow to produce the thin film in an industrial scale.

The physical vapor deposition can be performed by sputtering, ion plating, vacuum deposition, ion beam deposition or molecular beam deposition techniques, but high-frequency (RF) sputtering technique, more particularly, magnetron sputtering is most preferable. The power of the high-frequency is preferably less than 104 W/cm$^{-2}$, preferably less than 15 W/cm$^{-2}$. In the case of RF sputtering, the speed or rate of deposition increases with an increase of the high-frequency power. However, if the high-frequency power exceeds 104 W/cm$^{-2}$, arc discharge or abnormal discharge is apt to occur. Therefore, a high-frequency power which is less than 104 W/cm$^{-2}$, preferably less than 15 W/cm$^{-2}$, was used in the present invention.

The distance between a substrate and the target is preferably adjusted to a value from 3 to 300 mm, preferably from 15 to 300 mm. When the distance is too small, it is difficult to produce plasma between the substrate and the target. Particularly, in the case of the high-frequency magnetron sputtering technique, the plasma is converged or concentrated in the neighborhood of a magnet positioned behind the target and uniform deposition of the thin film cannot be produced if the distance between the substrate and the target is too small. Therefore, the distance must be larger than the predetermined minimum value. To the contrary, when the distance between the substrate and the target is too large, the deposition rate becomes too slow to effect practical deposition. Therefore, the distance is preferably adjusted from 3 mm to 300 mm, preferably from 15 mm to 300 mm.

The substrate on which the thin film is deposited is preferably heated by a heater at a temperature ranging from 260 °C to 1,500 °C during the sputtering operation.

It is also preferable to heat the obtained thin film additionally. An object of the heat-treatment is to homogenize the composition of the deposited thin film and to obtain the proper perovskite type oxide or quasi-perovskite type oxide. If the temperature of the heat-treatment is not higher than 750 °C, it is difficult to obtain the objective perovskite type oxide or quasi-perovskite type oxide which possesses the desired critical temperature of superconductivity or it takes an extremely longer time to complete the heat-treatment. To the contrary, if the temperature of the heat-treatment exceeds 1,500 °C, the objective perovskite type oxide or quasi-perovskite type oxide is exhausted or disappears, resulting in the lowering of the critical temperature.

The substrate may be made of any one of materials which are used in the field of the physical vapor deposition and may be selected from glass, quartz, silicon, stainless steel and ceramics such as MgO, BaTiO$_3$, sapphire, YSZ or the like.

The target according to the present invention can be also used in the ion plating technique in which an ion beam from an electron gun is directed onto the target.

The present invention provides a new superconducting material having very high Tc which permits the use of liquidized hydrogen or neon which are available cheaply and hence to enlarge the applications of superconductivity.

The sintered block obtained by the process of the present invention can be machined or molded into desired shapes and dimensions, so that a variety of superconducting products, such as a magnetic coil used under higher magnetic fields, a superconducting wire, a main part of superconducting power reservation or the like can be produced by adopting known technology used in the field of powder sintering.

The superconducting thin film prepared by the present invention can be utilized advantageously in the field of microelectronics, as Josephson device, SQUID (Superconducting Quantum Interference Device), infrared sensor or the like.

Now, an apparatus which can be used to realize the abovementioned process according to the present invention will be described with reference to the attached drawings which are not limitative of the present invention.

Brief description of the drawings

Figure 1 illustrates an example of a sputtering machine which can be used to carry out the process of the present invention.

Figure 2 shows an illustrative cross section of an embodiment of an ion plating machine which can be used in the process according to the present invention.

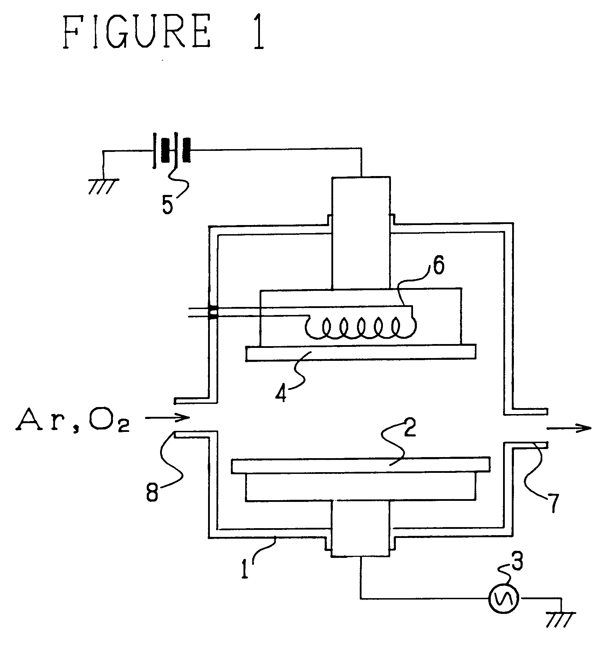

Figure 1 shows a sputtering machine which is used for carrying out the process according to the present invention and includes a vacuum chamber or bell jar 1, a material target 2 placed in the vacuum chamber 1, a high-frequency power source 3 connected to the target 2, and a substrate 4 on which the thin film is deposited and being faced to the target 2. A vacuum pump (not shown) connected through a port 7 to the interior of the chamber 1 functions to create vacuum therein.

Bias voltage is impressed on the substrate 4 from a source of high-voltage 5. The substrate 4 is heated by a heater 6 so that the temperature of the substrate is adjustable. The bell jar 1 has a gas inlet 8 for introducing argon gas.

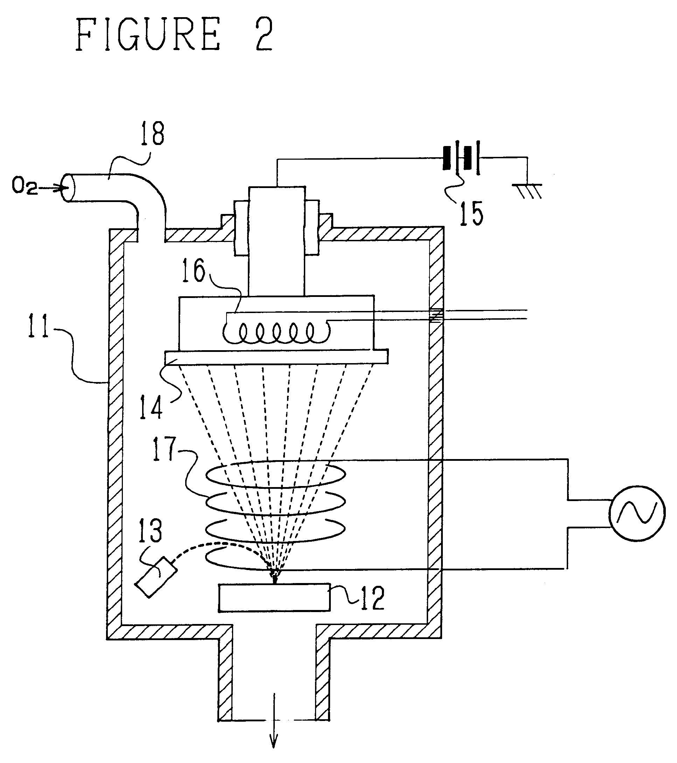

Figure 2 shows a high-frequency excitation type ion plating machine which can be used for carrying out the process according to the present invention and includes a vacuum chamber or bell jar 11, a material target 12 placed in the vacuum chamber 11, an electron gun 13 placed in the neighborhood of the target 12 for melting and evaporating material of the target 12, and a substrate 14 on which the thin film is deposited and being faced to the target 12. A vacuum pump (not shown) connected to the interior of the chamber 11 functions to create vacuum therein.

Bias voltage is impressed on the substrate 14 from a source of high-voltage 15. The substrate 14 is heated by a heater 16 so that the temperature of the substrate is adjustable. A high-frequency coil 17 is arranged in the bell jar 11 between the target 12 and the substrate 14 in such a manner that evaporated particles are enclosed by the coil. The bell jar 11 has a gas inlet 18 for introducing oxygen gas.

Now, embodiments of the process according to the present invention will be described with reference to illustrative Examples, but the scope of the present invention should not be limited thereto.

### Example 1

Into a mixture of 59.0 g of $BaCO_3$ powder of purity of 99.9 %, 45.0 g $Y_2O_3$ powder of purity of 99.9 % and 40.0 g of CuO powder of purity of 99.9 %, 2.0 g of $V_2O_5$ powder of purity of 99.9 % was added and crushed and mixed completely in a ball mill.

The resulting mixture was compacted in a mold and then sintered at 930 °C in air for 12.5 hours. The sintered body was pulverized and then compacted. The resulting compact was further sintered at 930 °C in air for 12 hours.

A test sample of 3 x 3 x 10 mm was cut from the resulting finally sintered body and then electrodes were connected to the test sample by vacuum-depositing gold on opposite ends of the test sample according to a common technique. Electrical resistance was determined by a four probe method. Temperature was measured by a calibrated Au(Fe)-Ag thermocouple.

Phenomenon of superconductivity was observed when the test sample was cooled below 21 K in liquidized hydrogen. Then, the temperature dependence of resistance of the test sample was determined while rising the temperature gradually. The result was that the resistance appears at 52 K and ordinary resistance was observed above 93 K. Therefore, the critical temperature (Tcf) of this test sample was 52 K and the onset temperature (Tc) was 93 K. The same result was observed by the measurement of AC susceptibility by L meter.

The critical current density (Jc) was also measured on a test sample prepared in the same manner as above. The Jc of 600 $A/cm^2$ was observed at 80K. Then, the external magnetic field was increased gradually and it was found that a Jc of 100 $A/cm^2$ was maintained in the field of 1 Tesla.

### Example 2

The same powders as in Example 1 were used. In this Example 2, 5.0 g of $Ta_2O_5$ powder of purity of 99.9 % was added to a mixture of 59.0 g of $BaCO_3$ powder of purity of 99.9 %, 45.0 g $Y_2O_3$ powder of purity of 99.9 % and 40.0 g of CuO powder of purity of 99.9 % and crushed and mixed completely in a ball mill.

The resulting mixture was compacted in a mold and then sintered at 930 °C in air for 12 hours. The sintered body was pulverized in a ball mill and then compacted. The resulting compact was further sintered at 930 °C in air for 12.5 hours.

A test sample of 3 x 3 x 10 mm was cut from the resulting finally sintered body and then temperature dependence of electrical resistance was determined by the same method as in Example 1. The result was that the critical temperature (Tcf) of this test sample was 76 K and the onset temperature (Tc) was 77 K, so that the discrepancy between Tcf and Tc was very small. The same result was observed by the measurement of AC susceptibility by L meter.

The critical current density (Jc) was also measured on a test sample prepared in the same manner as above. The Jc of 500 $A/cm^2$ was observed at 70K. Then, the external magnetic field was increased gradually and it was found that a Jc of 80 $A/cm^2$ was maintained in a field of 1 Tesla.

### Example 3

At first, powders of $BaCO_3$, $Y_2(CO_3)_3$, and CuO are mixed uniformly in such proportions that the atom ratio of Ba/(Ba+Y) is 0.4 and the atom ratio of Ba/Cu is 2/3. Then, powder of $V_2O_5$ was added to the mixture with such atom ratio that V/Ba is 0.67. Then, a compact of the powder mixture was subjected to a preliminary sintering at 820 °C for 12 hours. The resulting preliminary sintered mass is pulverized and then compacted again. The resulting compacted mass is further sintered finally at 1,080 °C to obtain a target of a sintered body. Sputtering is carried out on a substrate of silicon crystal under the following conditions:

| | |
|---|---|
| Partial pressure of oxygen | $5.33$ Pa ($4 \times 10^{-2}$ Torr) |
| Partial pressure of argon | $4.00$ Pa ($3 \times 10^{-2}$ Torr) |
| Temperature of the substrate | $700\ °C$ |
| Bias voltage imposed on the substrate | $-60$ V |
| High-frequency power | $25\ W/cm^{-2}$ |
| Distance between substrate and target | $40$ mm |

A film about 1 μm (micron) thick is obtained at a deposition rate of 3 0.3 nm/s (Angström/sec). For comparison, the same operation as above is repeated but no oxygen is introduced into the chamber.

To determine the electric resistance of the resulting thin film, a pair of electrodes of aluminum are vacuum-deposited on a surface of the thin film at opposite ends of the surface and a pair of lead wires are soldered to the deposited aluminum electrodes.

The result was that the thin film prepared under the partial pressure of oxygen of 5.33 Pa ($4 \times 10^{-2}$ Torr) according to the present invention showed the onset temperature (from which superconducting phenomenon started to appear) of 90 K and the critical temperature (at which the complete superconductor is obtained) of 50 K. On the other hand, in the comparative example in which a thin film is prepared without introducing oxygen, although the resulting thin film showed almost the same onset temperature, the electric resistance dropped rather gradually before it became zero at about 7 K. This fact revealed that introduction of oxygen into the chamber for controlling oxygen contents in the thin film during the film formation was critical to obtain a desired superconducting thin film.

The critical current density (Jc) was also measured on a test sample prepared in the same manner as above. The Jc of 2,000 A/cm$^2$ was observed at 70K. Then, the external magnetic field was increased gradually and it was found that a Jc of 840 A/cm$^2$ was maintained in a field of 1 Tesla.

## Example 4

At first, powders of $BaCO_3$, $Y_2(CO_3)_3$, and $CuO$ are mixed uniformly in such proportions that the atom ratio of Ba/(Ba+Y) is 0.4 and the atom ratio of Ba/Cu is 2/3. Then, powder of $Ta_2O_5$ was added to the mixture with such atom ratio that Ta/Ba is 0.77. Then, a compact of the powder mixture was subjected to a preliminary sintering at 820 °C for 12 hours. The resulting preliminary sintered mass is pulverized and then compacted again. The resulting compacted mass is further sintered finally at 1,080 °C to obtain a target of a sintered body. Sputtering is carried out on a substrate of silicon crystal under the same conditions as in Example 3.

A test sample to determine electric resistance of the resulting thin film was prepared in the same manner as in Example 3.

The result was that the thin film prepared according to the present invention showed the onset temperature (from which superconducting phenomenon started to appear) of 76 K and the critical temperature (at which the complete superconductor is obtained) of 75 K, so that the discrepancy between Tcf and Tc was very small.

In this sample, a critical current density (Jc) of 3,000 A/cm$^2$ was observed at 70K and a Jc of 1,000 A/cm$^2$ was maintained in the field of 1 Tesla at 70K.

## Claims

1. Superconducting copper-containing oxide having a composition represented by the general formula :
$$A_uB_vC_wCu_xO_y$$
in which,

"A" represents one element selected from elements of IIa group and IIIa group of the Periodic Table,

"B" represents one element selected from elements of IIa group and IIIa group of the Periodic Table,

"B" being selected from the group which "A" is not selected from,

"C" represents at least one element selected from a group consisting of V, Ta, Nb, Cr, Ga, In, Cd, Sn, Tl, Pb, Mo, W and Zn,

"u", "v", "w" and "x" represent numbers selected in a range of

7

$0<u<1$,
$0<v<1$,
$0<w<1$,
$0<x<1$ and
$1<y<4$,

and having a perovskite crystal structure.

2. The superconducting copper-containing oxide set forth in claim 1, wherein said oxide is in the form of a sintered body.

3. The superconducting copper-containing oxide set forth in claim 1, wherein said oxide is in the form of a thin film.

4. A process for producing a superconducting copper-containing oxide having a crystal structure of perovskite, characterized by the steps of preparing a powder mixture of

(1) a powder of oxide, carbonate, nitrate or sulfate of one element "A" selected from elements of IIa group and IIIa group of the Periodic Table,

(2) a powder of oxide, carbonate, nitrate or sulfate of one element "B" selected from elements of IIa group and IIIa group of the Periodic Table, "B" being selected from the group which "A" is not selected from,

(3) a powder of oxide, carbonate, nitrate or sulfate of a least one element "C" selected from a group consisting of V, Ta, Nb, Cr, Ga, In, Cd, Sn, Tl, Pb, Mo, W and Zn, and

(4) a powder of oxide, carbonate, nitrate or sulfate of Cu,

in such proportions that the atom ratios "u", "v", "w" and "x" of said elements "A":"B":"C":"Cu" in said powder mixture satisfy the following ranges :

$0<u<1$,
$0<v<1$,
$0<w<1$, and
$0<x<1$,

and then sintering said powder mixture in the presence of oxygen.

5. The process set forth in claim 4, wherein said sintering is carried out at a temperature ranging from 700°C to 1,600°C, preferably from 800°C to 1,000°C.

6. The process set forth in claim 4 or 5, wherein said sintering is effected by at least two stages including a preliminary sintering and a final sintering.

7. The process set forth in any one of claims 4 to 6, wherein said preliminary sintering is carried out at a temperature between 550°C and 950°C, and said final sintering is carried out at a temperature between 800°C and 930°C.

8. The process set forth in any one of claims 4 to 7, wherein the resulting sintered body is further heat-treated.

9. The process set forth in claim 8, wherein the heat-treatment is carried out at a temperature between 750 and 1,500°C.

10. The process set forth in claim 9, wherein said heat-treatment is carried out at a temperature between 750 and 930°C.

11. A process for preparing a thin film of superconducting copper-containing oxide having a crystal structure of perovskite on a substrate by physical vapour deposition, characterized by using, as a vapour source, a compound oxide of one element "A" selected from elements of IIa group and IIIa group of the Periodic Table, one element "B" selected from elements of IIa group and IIIa group of the Periodic Table "B" being selected from the group which "A" is not selected from, at least one element "C" selected from a group consisting of V, Ta, Nb, Cr, Ga, In, Cd, Sn, Tl, Pb, Mo, W and Zn, and copper, the atom ratios "u", "v", "w" and "x" of said elements "A":"B":"C":"Cu" satisfying the following ranges :

$0<u<1$,
$0<v<1$,

0<w<1, and

0<x<1.

12. The process set forth in claim 11, wherein said physical vapour deposition is effected by high-frequency sputtering, the power of high-frequency being lower than 104 W/cm$^{-2}$, preferably lower than 15 W/cm$^{-2}$.

13. The process set forth in claim 12, wherein said high-frequency sputtering is effected in an atmosphere containing Ar and $O_2$, the partial pressure of Ar being between 0.13 and 40 Pa (1.0 x 10$^{-3}$ and 3 x 10$^{-1}$ Torr), preferably between 0.67 and 40 Pa (5.0 x 10$^{-3}$ and 3 x 10$^{-1}$ Torr).

14. The process set forth in claim 13, wherein the partial pressure of $O_2$ is between 0.13 and 40 Pa (1.0 x 10$^{-3}$ and 3 x 10$^{-1}$ Torr).

15. The process set forth in any one of claims 12 to 14, wherein said sputtering is magnetron sputtering.

16. The process set forth in claim 11, wherein said physical vapour deposition is effected by ion plating, vacuum deposition, ion beam deposition or molecular beam deposition.

17. The process set forth in any one of claims 11 to 16, wherein said substrate is heated at a temperature between 260°C and 1,500°C during the deposition.

18. The process claimed in any one of claims 11 to 17, wherein said substrate is made of glass, quartz, silicon, stainless steel or ceramics.

19. The process set forth in any one of claims 11 to 18, wherein the resulting thin film is further heat-treated.


**Patentansprüche**

1. Supraleitendes kupfer-enthaltendes Oxid mit einer Zusammensetzung der folgenden allgemeinen Formel:

$$A_uB_vC_wCu_xO_y$$

wobei

"A" ein Element darstellt, ausgewählt aus Elementen der Gruppe IIa und der Gruppe IIIa des Periodensystems,

"B" ein Element darstellt, ausgewählt aus Elementen der Gruppe IIa und der Gruppe IIIa des Periodensystems, wobei "B" aus der Gruppe ausgewählt wird, aus der "A" nicht ausgewählt wird,

"C" wenigstens ein Element darstellt, ausgewählt aus einer Gruppe, bestehend aus V, Ta, Nb, Cr, Ga, In, Cd, Sn, Tl, Pb, Mo, W und Zn,

"u", "v", "w" und "x" Zahlen darstellen, ausgewählt in einem Bereich von

$0<u<1$,

$0<v<1$,

$0<w<1$,

$0<x<1$ und

$1<y<4$,

und mit einer Perowskit-Kristallstruktur.

2. Supraleitendes kupfer-enthaltendes Oxid nach Anspruch 1, wobei das Oxid in Form eines gesinterten Körpers vorliegt.

3. Supraleitendes kupfer-enthaltendes Oxid nach Anspruch 1, wobei das Oxid in Form eines dünnen Films vorliegt.

4. Verfahren zur Herstellung eines supraleitenden kupferenthaltenden Oxids mit einer Perowskit-Kristallstruktur,
**gekennzeichnet durch**
die Schritte zur Herstellung einer pulverförmigen Mischung aus

(1) einem Oxid-, Carbonat-, Nitrat- oder Sulfatpulver eines Elements "A", ausgewählt aus Elementen der Gruppe IIa und der Gruppe IIIa des Periodensystems,

(2) einem Oxid-, Carbonat-, Nitrat- oder Sulfatpulver eines Elements "B", ausgewählt aus Elementen der Gruppe IIa und der Gruppe IIIa des Periodensystems, wobei "B" ausgewählt wird aus der Gruppe, aus der "A" nicht ausgewählt wird,

(3) einem Oxid-, Carbonat-, Nitrat- oder Sulfatpulver wenigstens eines Elements "C", ausgewählt aus einer Gruppe, bestehend aus V, Ta, Nb, Cr, Ga, In, Cd, Sn, Tl, Pb, Mo, W und Zn, und

(4) einem Oxid-, Carbonat-, Nitrat- oder Sulfatpulver von Cu,

in solchen Anteilen, daß die Atomverhältnisse "u", "v", "w" und "x" der Elemente "A":"B":"C":"Cu" in der pulverförmigen Mischung die folgenden Bereiche erfüllen:

$$0<u<1,$$
$$0<v<1,$$
$$0<w<1, \text{ und}$$
$$0<x<1,$$

und anschließend Sintern der pulverförmigen Mischung in Gegenwart von Sauerstoff.

5. Verfahren nach Anspruch 4, wobei das Sintern bei einer Temperatur im Bereich von 700°C bis 1600°C, bevorzugt von 800°C bis 1000°C, durchgeführt wird.

6. Verfahren nach Anspruch 4 oder 5, wobei das Sintern in wenigstens 2 Stufen, einschließlich einer Vorsinterung und einer abschließenden Sinterung, bewirkt wird.

7. Verfahren nach irgendeinem der Patentansprüche 4 - 6, wobei die Vorsinterung bei einer Temperatur zwischen 550°C und 950°C und die abschließende Sinterung bei einer Temperatur zwischen 800°C und 930°C durchgeführt wird.

8. Verfahren nach irgendeinem der Patentansprüche 4 - 7, wobei der entstandene gesinterte Körper weiter hitzebehandelt wird.

9. Verfahren nach Anspruch 8, wobei die Hitzebehandlung bei einer Temperatur zwischen 750°C und 1500°C durchgeführt wird.

10. Verfahren nach Anspruch 9, wobei die Hitzebehandlung bei einer Temperatur zwischen 750°C und 930°C durchgeführt wird.

11. Verfahren zur Herstellung eines dünnen Films aus supraleitendem kupfer-enthaltendem Oxid mit einer Perowskit-Kristallstruktur auf einem Träger durch physikalische Ausscheidung aus der Dampfphase, gekennzeichnet durch
Verwendung, als eine Dampfquelle, einer Oxidverbindung eines Elements "A", ausgewählt aus Elementen der Gruppe IIa und der Gruppe IIIa des Periodensystems, eines Element "B", ausgewählt aus den Elementen der Gruppe IIa und IIIa des Periodensystems, wobei "B" ausgewählt wird aus der Gruppe, aus der "A" nicht ausgewählt wird, wenigstens eines Elements "C", ausgewählt von einer Gruppe, bestehend aus V, Ta, Nb, Cr, Ga, In, Cd, Sn, Tl, Pb, Mo, W und Zn, und Kupfer, wobei die Atomverhältnisse "u", "v", "w" und "x" der Elemente "A":"B":"C":"Cu" die nachfolgenden Bereiche erfüllen:

$$0<u<1,$$
$$0<v<1,$$
$$0<w<1, \text{ und}$$
$$0<x<1.$$

12. Verfahren nach Anspruch 11, wobei die physikalische Ausscheidung aus der Dampfphase durch Hochfrequenz-Zerstäubung bewirkt wird, wobei die Hochfrequenzleistung geringer als 104 W/cm$^{-2}$ ist, bevorzugt geringer als 15 W/cm$^{-2}$.

13. Verfahren nach Anspruch 12, wobei die Hochfrequenz-Zerstäubung in einer Atmosphäre bewirkt wird, die Ar und $O_2$ enthält, wobei der Partialdruck von Ar zwischen 0,13 und 40 Pa ($1,0 \times 10^{-3}$ und $3 \times 10^{-1}$ Torr) liegt, bevorzugt zwischen 0,67 und 40 Pa ($5,0 \times 10^{-3}$ und $3 \times 10^{-1}$ Torr).

14. Verfahren nach Anspruch 13, wobei der $O_2$-Partialdruck zwischen 0,13 und 40 Pa ($1,0 \times 10^{-3}$ und $3 \times 10^{-1}$ Torr) liegt.

15. Verfahren nach irgendeinem der Ansprüche 12 - 14, wobei die Zerstäubung eine Magnetron-Zerstäubung ist.

**16.** Verfahren nach Anspruch 11,
wobei die physikalische Ausscheidung aus der Dampfphase durch Ionenplattierung, Vakuumabscheidung, Ionenstrahlabscheidung oder Molekularstrahlabscheidung bewirkt wird.

**17.** Verfahren nach irgendeinem der Ansprüche 11 - 16,
wobei der Träger während der Abscheidung auf eine Temperatur zwischen 260°C und 1500°C erhitzt wird.

**18.** Verfahren nach irgendeinem der Ansprüche 11 - 17,
wobei der Träger aus Glas, Quarz, Silizium, rostfreiem Stahl oder Keramik besteht.

**19.** Verfahren nach irgendeinem der Ansprüche 11 - 18,
wobei der entstandene dünne Film weiter hitzebehandelt wird.

**Revendications**

**1.** Oxyde supraconducteur contenant du cuivre qui a une composition représentée par la formule générale :

$$A_uB_vC_wCu_xO_y$$

dans laquelle :

"A" représente un élément choisi parmi des éléments du groupe IIa et du groupe IIIa du tableau périodique,

"B" représente un élément choisi parmi des éléments du groupe IIa et du groupe IIIa du tableau périodique, "B" étant choisi dans le groupe dans lequel "A" n'est pas choisi,

"C" représente au moins un élément choisi dans un groupe formé de V, Ta, Nb, Cr, Ga, In, Cd, Sn, Tl, Pb, Mo, W et Zn,

"u", "v", "w" et "x" représentent des nombres choisis dans les intervalles :

$O<u<1,$
$O<v<1,$
$O<w<1,$
$O<x<1$ et
$1<y<4,$

et qui a une structure cristalline de type perovskite.

**2.** Oxyde supraconducteur contenant du cuivre selon la revendication 1, dans lequel l'oxyde se présente sous la forme d'un corps fritté.

**3.** Oxyde supraconducteur contenant du cuivre selon la revendication 1, dans lequel l'oxyde se présente sous la forme d'un film mince.

**4.** Procédé de production d'un oxyde supraconducteur contenant du cuivre qui a une structure cristalline de perovskite, caractérisé par les opérations consistant à préparer un mélange de poudres constitué :
(1) d'une poudre d'oxyde, carbonate, nitrate ou sulfate d'un élément "A" choisi parmi des éléments du groupe IIa et du groupe IIIa du tableau périodique,
(2) d'une poudre d'oxyde, carbonate, nitrate ou sulfate d'un élément "B" choisi parmi des éléments du groupe IIa et du groupe IIIa du tableau périodique, "B" étant choisi dans le groupe dans lequel "A" n'est pas choisi,
(3) d'une poudre d'oxyde, carbonate, nitrate ou sulfate d'au moins un élément "C" choisi dans le groupe formé de V, Ta, Nb, Cr, Ga, In, Cd, Sn, Tl, Pb, Mo, W et Zn, et
(4) d'une poudre d'oxyde, carbonate, nitrate ou sulfate de cuivre Cu,
dans des proportions telles que les rapports entre atomes "u", "v", "w" et "x" desdits éléments "A":"B":"C":"Cu" dans le mélange de poudres respectent les intervalles suivants :

$O<u<1,$
$O<v<1,$
$O<w<1$ et
$O<x<1,$

puis à fritter ledit mélange de poudres en présence d'oxygène.

5. Procédé selon la revendication 4, dans lequel on exécute le frittage à une température comprise entre 700 °C et 1 600 °C, de préférence entre 800 °C et 1 000 °C.

6. Procédé selon la revendication 4 ou 5, dans lequel on exécute le frittage en au moins deux phases comprenant un frittage préliminaire et un frittage final.

7. Procédé selon l'une quelconque des revendications 4 à 6, dans lequel on exécute le frittage préliminaire à une température comprise entre 550 °C et 950 °C et on exécute le frittage final à une température comprise entre 800 °C et 930 °C.

8. Procédé selon l'une quelconque des revendications 4 à 7, dans lequel on soumet le corps fritté obtenu à un traitement thermique supplémentaire.

9. Procédé selon la revendication 8, dans lequel on exécute le traitement thermique à une température comprise entre 750 et 1 500 °C.

10. Procédé selon la revendication 9, dans lequel on exécute le traitement thermique à une température comprise entre 750 et 930 °C.

11. Procédé pour préparer sur un substrat, un film mince d'oxyde supraconducteur contenant du cuivre ayant une structure cristalline de perovskite, par dépôt en phase vapeur par voie physique, caractérisé en ce qu'il consiste à utiliser, en tant que source de vapeur, un oxyde mixte d'un élément "A" choisi parmi des éléments du groupe IIa et du groupe IIIa du tableau périodique, d'un élément "B" choisi parmi des éléments du groupe IIa et du groupe IIIa du tableau périodique, "B" étant choisi dans le groupe dans lequel "A" n'est pas choisi, d'au moins un élément "C" choisi dans un groupe formé de V, Ta, Nb, Cr, Ga, In, Cd, Sn, Tl, Fb, Mo, W et Zn, et du cuivre, les rapports entre atomes "u", "v", "w" et "x" desdits éléments "A":"B":"C":"Cu" respectant les intervalles suivants :
$$O<u<1,$$
$$O<v<1,$$
$$O<w<1 \text{ et}$$
$$O<x<1.$$

12. Procédé selon la revendication 11, dans lequel on exécute le dépôt en phase vapeur par voie physique au moyen d'une pulvérisation cathodique haute fréquence, l'énergie à haute fréquence étant inférieure à 104 W/cm$^{-2}$, de préférence inférieure à 15 W/cm$^{-2}$.

13. Procédé selon la revendication 12, dans lequel on exécute la pulvérisation cathodique haute fréquence dans une atmosphère contenant Ar et $O_2$, la pression partielle d'Ar étant comprise entre 0,13 et 40 Pa (1,0 x 10$^{-3}$ et 3 x 10$^{-1}$ Torr), de préférence entre 0,67 et 40 Pa (5,0 x 10$^{-3}$ et 3 x 10$^{-1}$ Torr).

14. Procédé selon la revendication 13, dans lequel la pression partielle d'$O_2$ est comprise entre 0,13 et 40 Pa (entre 1,0 x 10$^{-3}$ et 3 x 10$^{-1}$ Torr).

15. Procédé selon l'une quelconque des revendications 12 à 14, dans lequel la pulvérisation cathodique est une pulvérisation cathodique à magnétron.

16. Procédé selon la revendication 11, dans lequel on exécute le dépôt en phase vapeur par voie physique au moyen d'un placage ionique, d'un dépôt sous vide, d'un dépôt par faisceau d'ions ou d'un dépôt par faisceau moléculaire.

17. Procédé selon l'une quelconque des revendications 11 à 16, dans lequel on porte la température du substrat à une valeur comprise entre 260 °C et 1 500 °C pendant le dépôt.

18. Procédé selon l'une quelconque des revendications 11 à 17, dans lequel le substrat est en verre, quartz, silicium, acier inoxydable ou matières céramiques.

19. Procédé selon l'une quelconque des revendications 11 à 18, dans lequel on soumet le film mince obtenu à un traitement thermique supplémentaire.

# FIGURE 1

$Ar, O_2$

# FIGURE 2